(19) Europäisches Patentamt
European Patent Office
Office européen des brevets

(11) Veröffentlichungsnummer: **0 212 439**
**B1**

(12) # EUROPÄISCHE PATENTSCHRIFT

(45) Veröffentlichungstag der Patentschrift: **16.05.90**

(51) Int. Cl.[5]: **C08F 20/30**, C08F 20/34, G03F 7/022

(21) Anmeldenummer: **86110845.4**

(22) Anmeldetag: **05.08.86**

(54) **Polymere Verbindungen und diese enthaltendes strahlungsempfindliches Gemisch.**

(30) Priorität: **13.08.85 DE 3528930**

(43) Veröffentlichungstag der Anmeldung:
**04.03.87 Patentblatt 87/10**

(45) Bekanntmachung des Hinweises auf die Patenterteilung:
**16.05.90 Patentblatt 90/20**

(84) Benannte Vertragsstaaten:
**AT BE CH DE FR GB IT LI NL SE**

(56) Entgegenhaltungen:
**EP-A- 0 000 496**
**EP-A- 0 001 803**
**EP-A- 0 126 397**
**GB-A- 119 667**
**GB-A- 1 119 667**
**US-A- 3 869 292**
**US-A- 4 025 710**

(73) Patentinhaber: **HOECHST AKTIENGESELLSCHAFT, Postfach 80 03 20, D-6230 Frankfurt am Main 80(DE)**

(72) Erfinder: **Schneller, Arnold, Dr. Dipl.-Chem., Asternweg 41, D-6500 Mainz 21(DE)**
Erfinder: **Sander, Jürgen, Dr. Dipl.-Chem., Eichkopfallee 27, D-6237 Liederbach(DE)**

EP 0 212 439 B1

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

**Beschreibung**

Die Erfindung betrifft neue wasserunlösliche, in wäßrig-alkalischen Lösungen lösliche polymere Verbindungen, die als Bindemittel für strahlungsempfindliche Gemische, insbesondere für die Herstellung von Photoresistschablonen und Druckplatten, geeignet sind.

Die erfindungsgemäßen Polymeren eignen sich insbesondere für positiv arbeitende strahlungs- bzw. lichtempfindliche Gemische auf Basis von 1,2-Naphthochinondiaziden oder von Kombinationen photolytisch aktivierbarer Säurespender mit säurespaltbaren Verbindungen; sie sind jedoch auch als Bindemittel für negativ arbeitende strahlungsempfindliche Gemische geeignet.

Positiv arbeitende lichtempfindliche Gemische, d. h. Gemische, deren Kopierschicht an den belichteten Stellen löslich wird, aus den genannten Bestandteilen sind bekannt.

Diese Gemische enthalten als alkalilösliche Bindemittel in der überwiegenden Mehrzahl Phenol-Formaldehyd-Kondensationsprodukte, insbesondere Novolake. Als weitere mögliche alkalilösliche Bindemittel werden Copolymerisate von Maleinsäureanhydrid und Styrol, von Vinylacetat und Crotonsäure, von Alkylmethacrylat, Butadien und Methacrylsäure (DE-A 31 07 526) sowie Polymerisate des Vinylphenols (DE-A 33 09 222) beschrieben. Diese Polymerisate werden offensichtlich nicht bevorzugt. Praktisch alle bekannten Handelsprodukte enthalten deshalb Novolake. Die Novolake als Bindemittel haben für bestimmte Anwendungszwecke Nachteile.

Die Kondensation von Phenolen oder Kresolen mit Formaldehyd unter sauren Bedingungen führt aufgrund der Polyfunktionalität der eingesetzten Phenole neben linearen zu stark verzweigten und cyclischen Produkten, die einen starken Einfluß auf die kopiertechnischen Eigenschaften ausüben. Die Korrelation dieser Eigenschaften mit Syntheseparametern ist oft sehr schwierig oder gar unmöglich. Eine ausführliche Diskussion dieser Problematik gibt T.R. Pampalone in Solid State Technology, Juni 1984, S. 115 ff. Danach können Novolake in ihren stofflichen Eigenschaften nur begrenzt variiert und den praktischen Erfordernissen angepaßt werden.

Für einen Einsatz als Bindemittel in Trockenresistschichten sind Novolake aufgrund ihres niedrigen Molekulargewichts zu spröde, so daß es bei der Verarbeitung oft zu Brüchen der Schicht kommt, z. B. beim Belichten im Kontakt mit einer Maske oder beim Laminieren als Trockenresist auf eine Trägeroberfläche. Diese Eigenschaft wirkt sich besonders stark bei den für Trockenresistmaterialien bevorzugten größeren Schichtdicken aus.

In Kombination mit o-Chinondiaziden werden Novolake in Positivdruckplatten eingesetzt. Zur Erhöhung der Druckauflage werden die Druckplatten nach dem Belichten und Entwickeln einige Minuten bei Temperaturen von ca. 200-250°C eingebrannt. Hierbei können niedermolekulare Bestandteile des Novolaks aus der Schicht entweichen und sich auf der freigelegten Aluminiumoberfläche festsetzen, was beim Druckprozeß zum Tonen, d. h. zu unerwünschter Farbannahme an Nichtbildstellen führt.

Diese mangelnde thermische Stabilität der Novolake ist auch verantwortlich für Bildverzerrungen bei der Herstellung von integrierten Schaltungen nach der Trockenätzmethode. Dabei treten Temperaturen oberhalb 150° C auf, die damit deutlich höher liegen als der Erweichungspunkt des Novolaks. Als Folge davon verlaufen die Bildstrukturen und führen zu einer geringeren Auflösung.

Polyvinylphenol wird in der DE-C 23 22 230 als Novolakersatz in Schichten mit o-Chinondiaziden vorgeschlagen. Obwohl die Plasmaresistenz und die Haftung auf Siliciumoberflächen grundsätzlich mit Novolaken vergleichbar sind, werden unbelichtete Photoresistschichten mit diesem Polymeren beim Entwickeln zu stark abgetragen. Mit zunehmendem Molekulargewicht nimmt der Abtrag zwar ab, liegt aber in den besten Fällen (MG = 25.000) immer noch etwa um den Faktor 100 höher als bei Schichten mit Novolaken (nach T.R. Pampalone, Solid State Technology, Juni 1984, S. 119). Nachteilig ist weiterhin die präparativ aufwendige Synthese und die geringe Polymerisationsneigung des monomeren Vinylphenols.

In der JP-A 51/36 129 werden Polymere auf Basis von Hydrochinon- und Dihydroxynaphthalinmonomethacrylat als Bindemittel für Naphthochinondiazidschichten beschrieben. Die Synthese dieser Monomeren erfordert einen aufwendigen Reinigungsschritt, da bei der Umsetzung eines Diols mit einem Säurechlorid der Diester in einem gewissen Prozentsatz entsteht und dieser bei der anschließenden Polymerisation bereits in Mengen von 0,5% zu einer vollständigen Vernetzung und damit Unlöslichkeit des Polymeren führt.

In der GB-A 1 119 667 werden Phenylester der Polyacrylsäure und deren Copolymerisate hergestellt, die aber nicht in alkalischen Lösungen löslich sind.

Aufgabe der Erfindung war es daher, alkalilösliche Polymere mit seitenständigen phenolischen OH-Gruppen vorzuschlagen, die keine spröden Schichten bilden, eine gute Entwickler- und Plasmaresistenz aufweisen und die sich einfach herstellen lassen.

Erfindungsgemäß wird ein in Wasser unlösliches, in wäßrig-alkalischen Lösungen aber lösliches Polymeres vorgeschlagen, das wiederkehrende Einheiten der allgemeinen Formel I

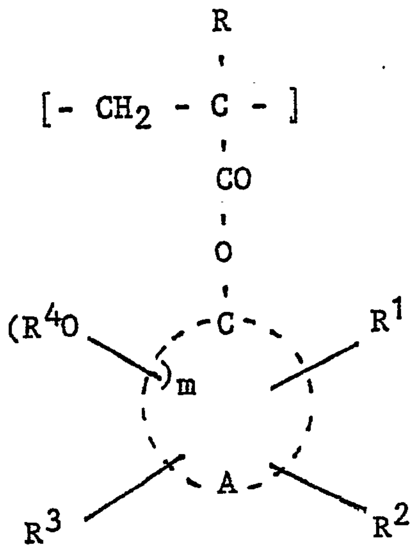

(I)

enthält, worin
R ein Wasserstoff- oder Halogenatom, eine Cyanidgruppe oder eine Alkylgruppe mit 1-4 Kohlenstoffatomen ist,
$R^1$, $R^2$ und $R^3$ gleich oder verschieden sind und Wasserstoff- oder Halogenatome, Alkyl-, Alkoxy- oder Alkoxycarbonylgruppen bedeuten,
$R^4$ ein Wasserstoffatom oder eine zweiwertige organische Gruppe ist, die mit einer weiteren Einheit der Formel I inter- oder intramolekular verknüpft ist, wobei im Mittel mindestens ein $R^4$ jeder Polymereinheit der Formel I Wasserstoff ist,
A die zur Vervollständigung eines ein- oder zweikernigen carbo- oder heterocyclischen aromatischen Ringsystems erforderlichen Atome bedeutet und
m 2 oder 3 ist.

Erfindungsgemäß wird ferner ein strahlungsempfindliches Gemisch vorgeschlagen, das als wesentliche Bestandteile

A) ein in Wasser unlösliches, in wäßrig-alkalischen Lösungen lösliches polymeres Bindemittel mit seitenständigen phenolischen Hydroxygruppen und
B) 1) ein 1,2-Chinondiazid oder
2) eine Kombination aus
a) einer unter Einwirkung von aktinischer Strahlung eine starke Säure bildenden Verbindung und
b) einer Verbindung mit mindestens einer durch Säure spaltbaren C-O-C-Bindung enthält, deren Löslichkeit in einem Entwickler durch Einwirkung von Säure erhöht wird.

Das erfindungsgemäße Gemisch ist dadurch gekennzeichnet, daß das Bindemittel ein in Wasser unlösliches, in wäßrig-alkalischen Lösungen aber lösliches Polymeres mit wiederkehrenden Einheiten der allgemeinen Formel I

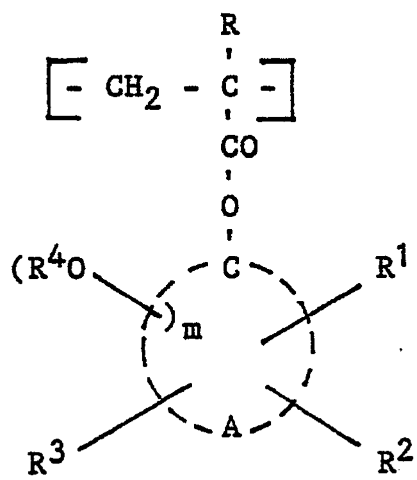

(I)

ist, worin

R ein Wasserstoff- oder Halogenatom, eine Cyanidgruppe oder eine Alkylgruppe mit 1-4 Kohlenstoffatomen ist,
$R^1$, $R^2$ und $R^3$ gleich oder verschieden sind und Wasserstoff- oder Halogenatome, Alkyl-, Alkoxy- oder Alkoxycarbonylgruppen bedeuten,
$R^4$ ein Wasserstoffatom oder eine zweiwertige organische Gruppe ist, die mit einer weiteren Einheit der Formel I inter- oder intramolekular verknüpft ist, wobei im Mittel mindestens ein $R^4$ jeder Polymereinheit der Formel I Wasserstoff ist,
A die zur Vervollständigung eines ein- oder zweikernigen carbo- oder heterocyclischen aromatischen Ringsystems erforderlichen Atome bedeutet und
m 2 oder 3 ist.

Das erfindungsgemäße Polymere kann ein Homopolymeres oder ein Copolymeres sein, das neben Einheiten der Formel I andere von copolymerisierbaren ethylenisch ungesättigten Monomeren abgeleitete Einheiten enthält. Die Comonomeren sind im allgemeinen Monovinylverbindungen. Sie können auch vernetzungsfähige Gruppen enthalten, die sich katalytisch oder thermisch vernetzen lassen. Die Vernetzung kann zur Härtung der Bildschablone nach dem Entwickeln, vorzugsweise durch Erhitzen, vorgenommen werden.

Wenn in der Formel I R eine Alkylgruppe ist, enthält diese im allgemeinen 1 bis 6, bevorzugt 1 oder 2 Kohlenstoffatome. Besonders bevorzugt werden Verbindungen mit R = H oder Methyl.

Von den Substituenten $R^1$, $R^2$ und $R^3$ ist bevorzugt mindestens einer ein Wasserstoffatom, besonders bevorzugt sind mindestens zwei davon Wasserstoffatome. Wenn diese Symbole Alkyl- oder Alkoxygruppen bedeuten, haben diese bevorzugt 1 bis 6, insbesondere 1 bis 3 Kohlenstoffatome. Allgemein sind hier unter Alkylgruppen verzweigte und unverzweigte, gesättigte und ungesättigte Gruppen mit cyclischen und offenen Ketten zu verstehen, die durch Halogenatome oder Hydroxygruppen substituiert sein oder Ether- oder Ketogruppen enthalten können. Bevorzugt werden unverzweigte Kohlenwasserstoffreste mit 1 bis 3 Kohlenstoffatomen.

Wenn das aromatische Ringsystem A heterocyclisch ist, kann es z. B. ein Pyridin-, Pyrimidin-, Pyrazin-, Chinolin-, Isochinolin-, Chinoxalin-, Indol- oder Thiophensystem sein. Als aromatische Ringsysteme kommen Benzol, Naphthalin und Biphenyl in Betracht; besonders bevorzugt wird ein Benzolring. m ist bevorzugt 2.

Die Stellung der Gruppen $OR^4$ unterliegt keinerlei Beschränkungen; sie richtet sich nach der präparativen Zugänglichkeit.

Die Stellung der Reste $R^1$, $R^2$ und $R^3$ richtet sich nach der Stellung der Gruppen $OR^4$.

Wenn $R^4$ eine zweiwertige Gruppe ist, liegt diese im Polymeren in solchem Mengenanteil vor, daß die Löslichkeit des Produkts nicht beeinträchtigt wird. Im allgemeinen enthalten nicht mehr als 20 mol-%, vorzugsweise nicht mehr als 10 mol-% der Einheiten der Formel I eine Gruppe $R^4O$, in der $R^4$ von H verschieden ist. $R^4$ kann in diesem Falle eine aromatische oder aliphatische Gruppe sein, die vorzugsweise 2 bis 15 Kohlenstoffatome enthält und z. B. durch Umsetzen eines Diepoxids oder Diisocyanats mit OH-Gruppen entstanden ist. Dabei werden als Reaktionspartner Diisocyanate bevorzugt. Beispiele für geeignete Diisocyanate sind Tolylen-, Hexamethylen-, 2,2,4-Trimethylhexamethylen-, Lysin-, Isophoron- und Diphenylmethandiisocyanat.

Beispiele für erfindungsgemäß geeignete Einheiten der Formel I sind solche aus Monoacrylaten oder -methacrylaten des Pyrogallols, Phloroglucins, Hydroxyhydrochinons, des 3,4,5-Trihydroxybenzoesäureethylesters, des 2,3,4-Trihydroxytoluols, des 3,3',4,4'-Tetrahydroxybiphenyls oder eines Trihydroxychinolins. Die Ester der Trihydroxybenzole, insbesondere des Pyrogallols, werden besonders bevorzugt.

Die Herstellung von bevorzugten Monomeren, die Einheiten der Formel I bilden, erfolgt in der Weise, daß man bei Trihydroxyaromaten, die mindestens zwei Hydroxygruppen in Nachbarstellung enthalten, diese Hydroxygruppen zunächst, z. B. durch Umsetzen mit Phosgen, in die cyclischen Carbonate überführt, dann die dritte Hydroxygruppe in den Ester einer Acrylsäure der Formel $CH_2{=}C(R){-}COOH$ überführt und schließlich das Carbonat wieder verseift. Weitere Monomere werden in Analogie zu bekannten Verfahren oder zu dem genannten Verfahren hergestellt.

Die Homopolymerisation dieser Monomeren oder deren Copolymerisation mit anderen Monomeren läßt sich nach konventionellen Methoden durchführen, beispielsweise in Gegenwart eines Polymerisationsinitiators wie Azo-bisisobuttersäurenitril in organischen Lösungsmitteln wie Butanon oder Ethanol bei erhöhten Temperaturen innerhalb von 1 bis 20 Stunden. Daneben ist aber auch eine Suspensions-, Emulsions- oder Massepolymerisation möglich, die auch durch Strahlung, Hitze oder ionische Initiatoren ausgelöst werden kann.

Die Polymeren mit Einheiten der Formel I können Homopolymerisate, welche ausschließlich Struktureinheiten der Formel I enthalten, oder Mischpolymerisate aus Monomeren entsprechend der Formel I und einem oder mehreren anderen Vinylmonomeren, gegebenenfalls auch solchen mit phenolischen Gruppen, sein.

Weiterhin können verschiedene Monomere entsprechend Formel I, z. B. Pyrogallolacrylat und Pyrogallolmethacrylat, miteinander, gegebenenfalls auch mit weiteren Vinylmonomeren, copolymerisiert werden.

Das Molekulargewicht der Homo- bzw. Copolymeren kann in weiten Grenzen variiert werden; bevor-

zugt werden Polymerisate mit $\overline{M}_n$ = 1000 - 200.000, besonders solche mit $\overline{M}_n$ = 5000 - 100.000. Die Hydroxylzahl liegt im allgemeinen im Bereich von 100 bis etwa 450, vorzugsweise zwischen 200 und 350.

Die Auswahl von geeigneten Homo- und Copolymeren richtet sich im Einzelfall nach dem Anwendungszweck und nach der Art der übrigen Komponenten in dem strahlungs- bzw. lichtempfindlichen Gemisch.

So ist die Hydrophilie des Bindemittels eines lichtempfindlichen Gemischs von Bedeutung für die Lichtempfindlichkeit, Entwicklungszeit und Entwicklerresistenz. Die Hydrophilie muß daher an das jeweilige lichtempfindliche System angepaßt werden. Systeme mit o-Chinondiaziden erfordern ein hydrophileres Bindemittel als Systeme mit säurespaltbaren Orthoester- oder Acetalgruppierungen.

Wichtig für die anwendungstechnischen Eigenschaften eines lichtempfindlichen Gemischs ist weiterhin seine Erweichungstemperatur, die wesentlich durch die des Bindemittels bestimmt wird. Für Druckplatten oder für Mikroresists für die Herstellung von integrierten Schaltungen wird eine hohe Erweichungstemperatur gefordert, um die eingangs erwähnten Nachteile wie Tonen oder Bildverzerrung zu vermeiden. Im Gegensatz dazu erfordert die Anwendung als Trockenresist ein System mit niedrigeren Erweichungspunkten, um eine trockene Schichtübertragung unter Druck und Erwärmen zu ermöglichen.

Das erfindungsgemäße Gemisch eröffnet die Möglichkeit, die genannten Eigenschaften gezielt zu variieren und auf die jeweiligen Anforderungen maßzuschneidern.

Dies läßt sich z. B. erreichen durch

- Variation der Reste R, $R^1$, $R^2$, $R^3$ und $R^4$
- Variation der Anzahl der phenolischen Gruppen
- Variation des Mengenverhältnisses an Einheiten der Formel I
- Variation des Mengenverhältnisses und der Art von zusätzlichen Comonomeren.

Die unten angeführten Beispiele illustrieren diese Möglichkeiten.

Als Comonomere für die Verbindungen, die zu Einheiten der Formel I polymerisieren, werden Verbindungen der allgemeinen Formel

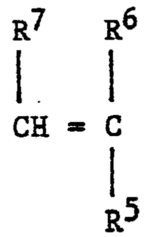

bevorzugt, worin

$R^5$ ein Wasserstoff- oder Halogenatom oder eine Alkylgruppe,

$R^6$ eine Alkyl-, Alkoxy-, Alkyloxycarbonyl-, Acyl-, Acyloxy-, Aryl-, Formyl-, Cyanid-, Carboxyl-, Hydroxy- oder Aminocarbonylgruppe und

$R^7$ ein Wasserstoffatom oder eine Carboxylgruppe ist, die mit $R^6$, wenn dieses eine Carboxylgruppe ist, zu einem Säureanhydrid verbunden sein kann.

Wenn $R^5$ oder $R^6$ Alkylgruppen sind, haben diese im allgemeinen 1 - 4 Kohlenstoffatome; als Vertreter für $R^6$ kommen in Betracht: Alkoxygruppen mit 1 - 8 C-Atomen, Alkyloxycarbonylgruppen mit 2 - 13 C-Atomen, Acylgruppen mit 2 - 9 C-Atomen und Acyloxygruppen mit 2 - 5 C-Atomen. Die Aminocarbonylgruppen können unsubstituiert oder durch eine oder zwei Alkylgruppen mit 1 - 8 C-Atomen substituiert sein. Die Alkylgruppen haben die oben angegebene Bedeutung.

Beispiele für solche Verbindungen sind Styrol, α-Chlorstyrol, α-Methylstyrol, 2-, 3- oder 4-Chlormethyl-styrol, 4-Brom-styrol, Methylvinylether, Ethylvinylether, Propylvinylether, Butylvinylether, Acrylnitril, Acrolein, Butadien, Acrylsäure, Methacrylsäure, die Methyl-, Ethyl-, Propyl-, Butyl-, Pentyl-, Hexyl-, Decyl-, Dodecyl-, 2-Ethylhexyl-, Phenyl-, Benzyl-, Biphenylyl- und Naphthylester dieser Säuren, Methacrylamid, Acrylamid, Vinylacetat, Vinylisobutylketon und Maleinsäureanhydrid.

Der Gehalt an Einheiten der Formel I im Copolymeren richtet sich nach den übrigen Komponenten des Gemischs und nach der Anwendung. Im allgemeinen werden im erfindungsgemäßen Gemisch Polymere mit einem Gehalt von 20 bis 100 mol-%, vorzugsweise 40 bis 100 mol-% an Einheiten der Formel I eingesetzt.

Zur Herstellung der erfindungsgemäßen Gemische wird das beschriebene Bindemittel kombiniert mit strahlungsempfindlichen Verbindungen bzw. Gemischen, deren Löslichkeit in einer wäßrig-alkalischen Entwicklerlösung beim Belichten oder unter Einwirkung energiereicher Strahlung erhöht wird. Hierzu gehören vor allem o-Chinondiazide und Kombinationen von photolytischen Säurespendern mit säurespaltbaren Verbindungen.

Als o-Chinondiazide (1,2-Chinondiazide) werden bevorzugt Naphthochinon-(1,2)-diazid-(2)-4- oder -5-sulfonsäureester oder -amide verwendet. Von diesen werden die Ester, insbesondere die der 5-Sulfonsäuren, besonders bevorzugt. Geeignete Verbindungen dieser Art sind bekannt und z. B. in der DE-C 938 233, den DE-A 21 31 377, 25 47 905 und 28 28 017 beschrieben.

Die Menge an o-Chinondiazidverbindungen beträgt im allgemeinen 3 bis 50, bevorzugt 7 bis 35 Gew.-%, bezogen auf die nichtflüchtigen Anteile des Gemischs. Die Menge des Bindemittels beträgt im allgemeinen 30 bis 90, bevorzugt 55 bis 85 Gew.-%, bezogen auf die gleiche Basis.

Als weitere Bestandteile kommen in bekannter Weise z. B. Weichmacher, Farbstoffe, Indikatoren, Pigmente, Sensibilisatoren und Verlaufmittel in Betracht.

Auch Materialien auf Basis säurespaltbarer Verbindungen lassen sich mit gutem Effekt in dem erfindungsgemäßen Gemisch einsetzen.

Als durch Säure spaltbare Verbindungen sind in erster Linie zu nennen:

(i) solche mit mindestens einer Orthocarbonsäureester- und bzw. oder Carbonsäureamidacetalgruppierung, wobei die Verbindungen auch polymeren Charakter haben und die genannten Gruppierungen als verknüpfende Elemente in der Hauptkette oder als seitenständige Substituenten auftreten können,
(ii) Oligomer- oder Polymerverbindungen mit wiederkehrenden Acetal- und/oder Ketalgruppierungen in der Hauptkette und
(iii) Verbindungen mit mindestens einer Enolether- oder N-Acyliminocarbonatgruppierung.

Durch Säure spaltbare Verbindungen des Typs (i) als Komponenten strahlungsempfindlicher Gemische sind in der EP-A 0 022 571 ausführlich beschrieben; Gemische, die Verbindungen des Typs (ii) enthalten, sind in der DE-C 23 06 248 und der DE-C 27 18 254 beschrieben; Verbindungen des Typs (iii) werden in den EP-A 0 006 626 und 0 006 627 beschrieben.

Die Art und die Menge des Bindemittels und der spaltbaren Verbindung kann je nach Anwendungsart verschieden sein; bevorzugt werden Anteile des Bindemittels zwischen 30 und 90 Gew.-%, besonders bevorzugt 55 bis 85 Gew.-%. Der Anteil der spaltbaren Verbindung kann variiert werden zwischen 5 und 70 Gew.-%, bevorzugt werden 5 bis 40 Gew.-%. Zusätzlich können noch zahlreiche andere Oligomere und Polymere mitverwendet werden, z. B. Phenolharze vom Novolaktyp oder Vinylpolymerisate wie Polyvinylacetale, Polymethacrylate, Polyacrylate, Polyvinylether und Polyvinylpyrrolidone, die selbst durch Comonomere modifiziert sein können.

Der günstigste Anteil an diesen Zusätzen richtet sich nach den anwendungstechnischen Erfordernissen und dem Einfluß auf die Entwicklungsbedingungen und beträgt im allgemeinen nicht mehr als 40 % vom Polymerisat mit Einheiten der Formel I. In geringen Mengen kann die lichtempfindliche Schicht für spezielle Erfordernisse wie Flexibilität, Haftung, Glanz etc. außerdem noch Substanzen wie Polyglykole, Celluloseether, z. B. Ethylcellulose, Netzmittel, Verlaufmittel, Farbstoffe und feinteilige Pigmente enthalten.

Als strahlungsempfindliche Komponenten, die beim Bestrahlen vorzugsweise starke Säuren bilden bzw. abspalten, sind eine große Anzahl von bekannten Verbindungen und Mischungen, wie Diazonium-, Phosphonium-, Sulfonium- und Jodonium-Salze, Halogen-Verbindungen, o-Chinondiazidsulfochloride und Organometall-Organohalogen-Kombinationen geeignet.

Die genannten Diazonium-, Phosphonium-, Sulfonium- und Jodonium-Verbindungen werden in der Regel eingesetzt in Form ihrer in organischen Lösungsmitteln löslichen Salze, meist als Abscheidungsprodukt mit komplexen Säuren wie Borfluorwasserstoffsäure, Hexafluorphosphor-, Hexafluorantimon- und -arsensäure.

Grundsätzlich sind als halogenhaltige strahlungsempfindliche und Halogenwasserstoffsäure bildende Verbindungen alle auch als photochemische Radikalstarter bekannten organischen Halogenverbindungen, beispielsweise solche mit mehr als einem Halogenatom an einem Kohlenstoffatom oder an einem aromatischen Ring, brauchbar. Beispiele sind in den US-A 3 515 552, 3 536 489 und 3 779 778, der DE-C 26 10 842 und den DE-A 22 43 621, 27 18 259 und 33 37 024 beschrieben. Von diesen Verbindungen werden die s-Triazinderivate mit 2 Halogenmethylgruppen, insbesondere Trichlormethylgruppen, und einem aromatischen bzw. ungesättigten Substituenten im Triazinkern, wie sie in den DE-A 27 18 259 und 33 37 024 beschrieben sind, bevorzugt. Die Wirkung dieser halogenhaltigen Verbindungen kann auch durch bekannte Sensibilisatoren spektral beeinflußt und gesteigert werden.

Beispiele für geeignete Starter sind: 4-(Di-n-propylamino)-benzoldiazoniumtetrafluoroborat, 4-p-Tolylmercapto-2,5-diethoxy-benzoldiazoniumhexafluorophosphat und -tetrafluoroborat, Diphenylamin-4-diazoniumsulfat, 4-Methyl-6-trichlormethyl-2-pyron, 4-(3,4,5-Trimethoxy-styryl)-6-trichlormethyl-2-pyron, 4-(4-Methoxy-styryl)-6-(3,3,3-trichlor-propenyl)-2-pyron, 2-Trichlormethyl-benzimidazol, 2-Tribrommethyl-chinolin, 2,4-Dimethyl-1-tribromacetyl-benzol, 3-Nitro-1-tribromacetyl-benzol, 4-Dibromacetyl-benzoesäure, 1,4-Bis-dibrommethyl-benzol, Tris-dibrommethyl-s-triazin, 2-(6-Methoxy-naphth-2-yl)-, 2-(Naphth-1-yl)-, 2-(Naphth-2-yl)-, 2-(4-Ethoxy-ethyl-naphth-1-yl)-, 2-(Benzopyran-3-yl)-, 2-(4-Methoxy-anthrac-1-yl)-, 2-(4-Styryl-phenyl)-, 2-(Phenanthr-9-yl)-4,6-bis-trichlormethyl-s-triazin und die in den Beispielen angeführten Verbindungen.

Die Menge des Starters kann je nach seiner chemischen Natur und der Zusammensetzung des Gemischs ebenfalls sehr verschieden sein. Günstige Ergebnisse werden erhalten mit etwa 0,1 bis 10 Gew.-%, bezogen auf den Gesamtfeststoff, bevorzugt sind 0,2 bis 5 %. Besonders für Kopierschichten von Dicken über 10 µm empfiehlt es sich, relativ wenig Säurespender zu verwenden.

Schließlich können dem lichtempfindlichen Gemisch noch lösliche oder auch feinteilige dispergierbare Farbstoffe sowie je nach Anwendungszweck auch UV-Absorber zugesetzt werden. Als Farbstoffe haben sich die Triphenylmethanfarbstoffe, insbesondere in der Form ihrer Carbinolbasen, besonders bewährt. Die günstigsten Mengenverhältnisse der Komponenten lassen sich im Einzelfall durch Vorversuche leicht ermitteln.

Als Schichtträger für die lichtempfindlichen Gemische eignen sich alle üblicherweise in der Technik in Kopierprozessen eingesetzten Materialien. Als Beispiele seien Kunststoffolien, Isolierplatten mit Kupferauflage, mechanisch oder elektrochemisch aufgerauhtes und ggf. anodisiertes Aluminium, Siebdruckschablonenträger, Holz, Keramik, Glas und Silicium, dessen Oberfläche chemisch z. B. in Siliciumnitrid oder Siliciumdioxid umgewandelt sein kann, genannt.

Bevorzugte Träger für dicke Schichten über 10 µm sind Kunststoffolien, die dann als temporäre Träger für Transferschichten dienen. Dafür und für Farbfolien werden Polyesterfolien, z. B. aus Polyethylenterephthalat, bevorzugt. Polyolefinfolien wie Polypropylen sind jedoch ebenfalls geeignet. Als Schichtträger für Schichtdicken unter ca. 10 m werden meist Metalle verwendet. Für Offsetdruckplatten können eingesetzt werden: mechanisch oder chemisch aufgerauhtes und gegebenenfalls anodisiertes Aluminium, das zudem noch chemisch, z. B. mit Polyvinylphosphonsäure, Silikaten oder Phosphaten, vorbehandelt sein kann.

Schließlich kann die Beschichtung direkt oder durch Schichtübertragung vom temporären Schichtträger erfolgen auf Leiterplatten-Materialien, die aus Isolierplatten mit ein- oder beidseitiger Kupferauflage bestehen, auf Glas oder Keramik-Materialien, die gegebenenfalls haftvermittelnd vorbehandelt sind, und auf Silicium-Scheiben. Außerdem können Holz, Textilien und Oberflächen vieler Werkstoffe beschichtet werden, die vorteilhaft durch Projektion bebildert werden und resistent gegen die Einwirkung alkalischer Entwickler sind.

Für die Trocknung nach der Beschichtung können die üblichen Geräte und Bedingungen übernommen werden, Temperaturen um 100°C und kurzfristig bis 120°C werden ohne Einbuße an Strahlungsempfindlichkeit vertragen.

Zum Belichten können die üblichen Lichtquellen wie Röhrenlampen, Xenonimpulslampen, metallhalogeniddotierte Quecksilberdampf-Hochdrucklampen und Kohlebogenlampen verwendet werden.

Unter Bestrahlung ist in dieser Beschreibung die Einwirkung aktinischer elektromagnetischer Strahlung im Wellenlängenbereich unterhalb etwa 500 nm zu verstehen. Alle in diesem Wellenlängenbereich emittierenden Strahlungsquellen sind prinzipiell geeignet.

Mit Vorteil werden Laserbestrahlungsgeräte, insbesondere automatische Verarbeitungsanlagen verwendet, die als Strahlungsquelle einen Argon-Ionen-Laser enthalten.

Die Bestrahlung kann auch mit Elektronenstrahlen erfolgen. In diesem Falle können auch im üblichen Sinne nicht lichtempfindliche Säure bildende Verbindungen als Initiatoren der Solubilisierungsreaktion eingesetzt werden, z. B. halogenierte aromatische Verbindungen oder halogenierte polymere Kohlenwasserstoffe. Röntgen- oder Ionenstrahlen können ebenfalls zur Bilderzeugung verwendet werden.

Die bildmäßig belichtete oder bestrahlte Schicht kann in bekannter Weise mit den für handelsübliche Naphthochinondiazid-Schichten und Kopierlacke bekannten Entwicklern entfernt werden, und die neuen Materialien können in ihrem Kopierverhalten mit Vorteil auf die bekannten Hilfsmittel wie Entwickler und programmierte Sprühentwicklungsgeräte abgestimmt werden. Die wäßrigen Entwicklerlösungen können z. B. Alkaliphosphate, -silikate oder -hydroxide und ferner Netzmittel sowie ggf. kleinere Anteile organischer Lösungsmittel enthalten. In bestimmten Fällen sind auch Lösungsmittel-Wasser-Gemische als Entwickler brauchbar. Die Wahl des günstigsten Entwicklers kann durch Versuche mit der jeweils verwendeten Schicht ermittelt werden. Bei Bedarf kann die Entwicklung mechanisch unterstützt werden.

Bei der Anwendung als Druckplatten können zur Erhöhung der Widerstandsfähigkeit beim Druck sowie der Resistenz gegen Auswaschmittel, Korrekturmittel und durch UV-Licht härtbare Druckfarben die entwickelten Platten kurze Zeit auf erhöhte Temperaturen erwärmt werden, wie es für Diazoschichten aus der GB-A 1 154 749 bekannt ist.

Erfindungsgemäß wird auch ein Verfahren zur Herstellung von Reliefbildern vorgeschlagen, bei dem man ein strahlungsempfindliches Aufzeichnungsmaterial aus einem Schichtträger und einer Aufzeichnungsschicht, die aus dem eingangs definierten strahlungsempfindlichen Gemisch besteht, bildmäßig mit aktinischer Strahlung in solcher Dosis bestrahlt, daß die Löslichkeit der Schicht in einer wäßrig-alkalischen Entwicklerlösung zunimmt, und die bestrahlten Schichtteile mittels einer wäßrig-alkalischen Entwicklerlösung entfernt. Das Verfahren ist dadurch gekennzeichnet, daß die Aufzeichnungsschicht als Bindemittel ein Polymerisat mit Einheiten der allgemeinen Formel I enthält.

Durch die Erfindung sind Positivschichten zugänglich, deren Eigenschaften sich je nach den anwendungstechnischen Erfordernissen gezielt einstellen lassen. Durch die geeignete Wahl der erfindungsgemäßen Bindemittel lassen sich z. B. Positivschichten für die Anwendung in dünner Schicht erhalten, die eine ausgezeichnete Haftung zum Substrat sowie eine hervorragende Temperatur-, Ätz- und Abriebbeständigkeit aufweisen.

Andererseits lassen sich mit den hier vorgeschlagenen Bindemitteln auch Positivschichten für Anwendungen in größeren Schichtdicken von etwa 15 µm bis 100 µm und darüber, z. B. als Trockenresist, erhalten. Diese trockenen Filme weisen eine hohe Lichtempfindlichkeit und eine ausgezeichnete Flexibilität auf und lassen sich einwandfrei von der Rolle verarbeiten.

Allgemeine Vorschrift zur Herstellung der Polymerisate

In einem Vierhalskolben mit Rührer, Rückflußkühler, Innenthermometer und Tropftrichter werden 40 Vt. Ethanol unter Sauerstoffausschluß zum Sieden erhitzt. Im Verlauf von 3 Stunden wird bei leichtem

Rückfluß ein Gemisch aus 40 Gt. des oder der Monomeren, gelöst in 60 Gt. Ethanol, und 0,4 Gt. Azo-bis-isobuttersäurenitril zugetropft. Man läßt noch 12 Stunden nachreagieren und tropft anschliessend die abgekühlte Lösung, nach eventuellem Verdünnen mit Ethanol, unter starkem Rühren in ca. 10.000 Vt. Wasser. Das ausgefallene, farblose Polymere wird abgesaugt, gewaschen und 48 Stunden im Vakuum bei 50°C getrocknet.

In Tabelle 1 sind die auf diesem Wege hergestellten Polymeren zusammengestellt.

Tabelle 1

Hergestellte Polymere mit Einheiten der Typen

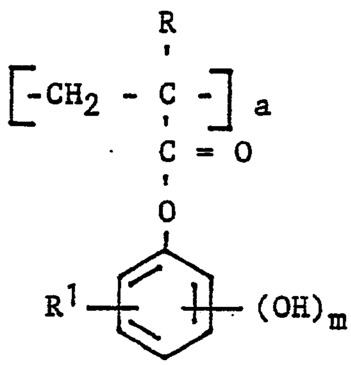

und

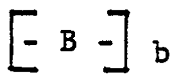

| Nr. des Polym. | R | m | Pos. OH | $R^1$ | Pos. $R^1$ | B | a : b (mol-%) |
|---|---|---|---|---|---|---|---|
| 1 | H | 2 | 2,3 | H | - | - | - |
| 2 | $CH_3$ | 2 | 2,3 | H | - | - | - |
| 3 | H | 2 | 2,3 | $COOC_2H_5$ | 5 | - | - |
| 4 | $CH_3$ | 2 | 2,3 | $COOC_2H_5$ | 5 | - | - |
| 5 | H | 2 | 2,3 | H | - | MMA | 30 : 70 |
| 6 | H | 2 | 2,3 | H | - | " | 40 : 60 |
| 7 | H | 2 | 2,3 | H | - | " | 50 : 50 |
| 8 | $CH_3$ | 2 | 2,3 | H | - | EHMA | 60 : 40 |
| 9 | $CH_3$ | 2 | 2,3 | H | - | " | 65 : 35 |
| 10 | $CH_3$ | 2 | 2,3 | H | - | " | 70 : 30 |
| 11 | $CH_3$ | 2 | 2,3 | H | - | " | 85 : 15 |
| 12 | $CH_3$ | 2 | 2,3 | H | - | BMA | 50 : 50 |
| 13 | $CH_3$ | 2 | 2,3 | H | - | " | 80 : 20 |
| 14 | $CH_3$ | 2 | 2,3 | H | - | " | 90 : 10 |
| 15 | $CH_3$ | 2 | 2,3 | $COOC_2H_5$ | 5 | HMA | 60 : 40 |

Tabelle 1 (Fortsetzung)

| Nr. des Polym. | R | m | Pos. OH | $R^1$ | Pos. $R^1$ | B | a : b (mol-%) |
|---|---|---|---|---|---|---|---|
| 16 | $CH_3$ | 2 | 3,4 | H | - | HMA | 60 : 40 |
| 17 | $CH_3$ | 2 | 3,4 | H | - | " | 70 : 30 |
| 18 | $CH_3$ | 2 | 3,4 | H | - | BMA | 80 : 20 |
| 19 | $CH_3$ | 2 | 3,5 | H | - | EHMA | 60 : 40 |
| 20 | $CH_3$ | 2 | 3,5 | H | - | S | 70 : 30 |
| 21 | $CH_3$ | 2 | 2,6 | H | - | - | - |
| 22 | $CH_3$ | 2 | 2,6 | H | - | HMA | 75 : 25 |
| 23 | $CH_3$ | 3 | 3,4,5 | H | - | BuMa | 60 : 40 |
| 24 | $CH_3$ | 3 | 3,4,5 | H | - | BMA | 65 : 35 |
| 25 | $CH_3$ | 3 | 3,4,6 | H | - | HMA | 70 : 30 |
| 26 | $CH_3$ | 3 | 3,4,6 | H | - | - | - |

| | |
|---|---|
| BMA | Biphenylyl-4-methacrylat |
| BuMA | n-Butylmethacrylat |
| EHMA | 2-Ethylhexylmethacrylat |
| HMA | n-Hexylmethacrylat |
| MMA | Methylmethacrylat |
| S | Styrol |

Die in der Tabelle 1 beschriebenen Polymeren lassen sich im Gemisch mit lichtempfindlichen Systemen zu Reproduktionsschichten verarbeiten. Die folgenden Beispiele zeigen die vielfältigen anwendungstechnischen Möglichkeiten dieser Bindemittel in den erfindungsgemäßen Gemischen.

Prozent- und Gewichtsangaben sind, wenn nicht anders angegeben, in Gewichtseinheiten zu verstehen. Gewichtsteile (Gt) und Volumteile (Vt) stehen im Verhältnis von g zu ml.

Für verschiedene Anwendungsmöglichkeiten werden die folgenden Beschichtungslösungen hergestellt:

Beschichtungslösung A:

8 Gt Bindemittel
1 Gt des Veresterungsprodukts aus 1 mol 2,3,4-Trihydroxybenzophenon und 3 mol Naphthochinon(1,2)-diazid-(2)-5-sulfonsäurechlorid und
0,01 Gt Kristallviolettbase in
80 Gt 1-Methoxy-propanol-2 und
20 Gt Butylacetat

Beschichtungslösung B:

40 Gt Bindemittel
10 Gt des Polyacetals aus Triethylenglykol und Butyraldehyd

0,5 Gt 2-(4-Ethoxy-naphth-1-yl)-4,6-bis-trichlormethyl-s-triazin und
0,05 Gt Kristallviolettbase in
110 Gt Butanon

Beschichtungslösung C:

40 Gt Bindemittel
8 Gt eines polymeren Orthoesters, hergestellt durch Kondensation von Orthoameisensäuretrimethylester mit 4-Oxa-6,6-bis-hydroxymethyl-octan-1-ol
0,5 Gt 2-(4-Styrylphenyl)-4,6-bis-trichlormethyl-s-triazin und
0,05 Gt Kristallviolettbase in
80 Gt Butanon und
20 Gt Ethanol

Beschichtungslösung D:

26,5 Gt Bindemittel und
3,5 Gt des Naphthochinondiazids aus Beschichtungslösung A in
70 Gt eines Lösungsmittelgemischs aus 1-Methoxypropanol-2, Butylacetat un Xylol (8:1:1)

Beschichtungslösung E:

20 Gt Bindemittel
6,5 Gt eines Kresol-Formaldehyd-Novolaks mit einem Erweichungsbereich von 105–120°C und
3,5 Gt des Naphthochinondiazids aus Beschichtungslösung A in
70 Gt eines Lösungsmittelgemischs aus 1-Methoxypropanol-2, Butylacetat und Xylol (8:1:1)

Beschichtungslösung F:

10 Gt Bindemittel
3 Gt des Bis-(5-butyl-5-ethyl-1,3-dioxan-2-yl)-ethers des 2-Butyl-2-ethylpropandiols und
0,25 Gt 2-(Acenaphth-5-yl)-4,6-bis-trichlormethyl-s-triazin in
90 Gt Butanon

Beispiele 1 bis 16:

Zur Herstellung von Offsetdruckplatten werden Bindemittel der Tabelle 1 entsprechend den Angaben der Beschichtungslösungen A, E und F mit den dort angegebenen Komponenten gemischt (siehe Tabelle 2).

Tabelle 2:

| Beispiel Nr. | Polymeres Nr. | Beschichtungslösung | Belichtungszeit (s) | Entwicklungszeit (s) |
|---|---|---|---|---|
| 1 | 1 | E | 100 | 60 |
| 2 | 2 | E | 100 | 60 |
| 3 | 3 | E | 100 | 70 |
| 4 | 4 | E | 100 | 80 |
| 5 | 9 | F | 20 | 40 |
| 6 | 11 | A | 100 | 55 |
| 7 | 13 | F | 20 | 40 |
| 8 | 14 | A | 100 | 50 |
| 9 | 15 | E | 100 | 60 |
| 10 | 17 | A | 100 | 80 |
| 11 | 18 | F | 20 | 70 |
| 12 | 20 | F | 20 | 70 |
| 13 | 21 | E | 100 | 90 |
| 14 | 22 | F | 20 | 40 |
| 15 | 24 | F | 40 | 70 |
| 16 | 25 | A | 100 | 60 |

Diese Lösungen werden auf elektrolytisch aufgerauhte und anodisierte Aluminiumplatten, die zuvor mit einer wäßrigen Lösung von Polyvinylphosphonsäure behandelt worden sind, aufgeschleudert. Durch Einstellung der Umdrehungszahl der Schleuder wird die Schichtdicke (trocken) bei allen Platten auf ca. 1,5 µm gebracht.

Anschließend werden die Platten 10 Minuten bei 100 °C im Umluftschrank getrocknet.

Nach Belichten unter einer 5 kW-Metallhalogenidlampe in 110 cm Abstand und nach einer Wartezeit von 10 Minuten für die nach Beschichtungslösung F hergestellten Schichten werden die Platten in einer Lösung aus

5,3 Gt Natriummetasilikat × 9 $H_2O$,
3,4 " Trinatriumphosphat × 12 $H_2O$ und
0,3 " Natriumdihydrogenphosphat (wasserfrei) in
91,0 " Wasser

entwickelt, wobei die vom Licht getroffenen Anteile der Kopierschicht entfernt werden, so daß die unbelichteten Bildstellen auf der Platte zurückbleiben.

In Tabelle 2 sind die eingesetzten Bindemittel, die jeweils verwendeten Beschichtungslösungen sowie die Belichtungs- und Entwicklungszeiten für die einzelnen Schichten zusammengestellt.

Von den so hergestellten Druckformen konnten nach Einfärbung mit oleophiler Druckfarbe in einer Offsetdruckmaschine 100.000 einwandfreie Drucke hergestellt werden.

Beispiele 17 bis 25

Zur Herstellung eines Positiv-Trockenresists werden Bindemittel aus Tabelle 1 entsprechend den Angaben der Beschichtungslösungen B und C mit den übrigen Komponenten gemischt (siehe Tabelle 3).

Diese Lösungen werden jeweils auf 26 µm dicke, biaxial verstreckte und thermofixierte Polyethylenterephthalatfolien aufgeschleudert und anschließend 10 Minuten bei 100 °C im Umlufttrockenschrank nachgetrocknet. Die Umdrehungszahl der Schleuder wird so reguliert, daß eine Schichtdicke von ca. 25 µm erhalten wird. Zum Schutz gegen Staub und Verkratzungen wird darauf noch eine Polyethylenfolie kaschiert.

Als Vergleich wird ein Trockenresist mit ausschließlich Kresol-Formaldehyd-Novolak als Bindemittel hergestellt (Beispiel 25).

Die Trockenresists mit den erfindungsgemäßen Bindemitteln zeigen eine deutlich verbesserte Flexibilität gegenüber dem Trockenresist mit Novolak. Während der novolakhaltige Resist beim Laminieren oder beim Falten leicht reißt, treten diese Nachteile bei den mit den neuen Bindemitteln hergestellten Trockenresists nicht auf.

Zur Herstellung von Leiterplatten werden die Trockenresists nach Abziehen der Deckfolie in einem handelsüblichen Laminator auf einen gereinigten, vorgewärmten Träger, der aus einer Isolierstoffplatte mit 35 µm dicker Kupferauflage besteht, laminiert. Nach Abziehen der Trägerfolie und eventuellem Nachtrocknen wird unter einer Vorlage mit einer 5 kW-Metallhalogenidlampe in 110 cm Abstand belichtet und nach einer Wartezeit von 10 Minuten in dem in den Beispielen 1 bis 16 angegebenen Entwickler entwickelt.

Die auf diese Weise entstandenen Resistschablonen weisen eine hervorragende Galvanoresistenz auf, insbesondere bei dem galvanischen Aufbau von Kupfer und Pb/Sn-Legierungen.

Derartig behandelte Platten lassen sich anschließend erneut belichten und entwickeln. Mit dieser Arbeitsweise lassen sich in einem ersten Schritt Lötaugen aus Pb/Sn an den Bohrlöchern galvanisieren, in einem zweiten Belichtungs- und Entwicklungsschritt läßt sich dann das Leiterbahnbild auf die noch lichtempfindliche Resistschablone übertragen. Nach dem Ätzen des freigelegten Kupfers mit ammoniakalischer Cu(II)-chlorid-Lösung erhält man eine Leiterplatte in Kupfertechnik, d. h. die Pb/Sn-Legierung wird nur dort aufgebaut, wo sie beim nachfolgenden Lötprozeß benötigt wird.

Tabelle 3

| Beispiel Nr. | Polymeres Nr. | Beschichtungs-lösung | Belichtungs-zeit (s) | Entwicklungs-zeit (s) |
|---|---|---|---|---|
| 17 | 7 | B | 20 | 50 |
| 18 | 9 | C | 20 | 40 |
| 19 | 10 | B | 20 | 90 |
| 20 | 15 | B | 20 | 45 |
| 21 | 19 | B | 10 | 50 |
| 22 | 22 | C | 10 | 50 |
| 23 | 23 | C | 10 | 30 |
| 24 | 25 | B | 50 | 30 |
| 25 (V) | Kresol-Novolak | B | 30 | 60 |

(V) Vergleichsversuch

Beispiele 26 bis 37

Zur Herstellung mikroelektronischer Schaltelemente hoher Integration werden nach Angaben der Beschichtungslösungen D, E und F in Tabelle 1 angegebene Bindemittel mit den übrigen Komponenten gemischt (siehe Tabelle 4). Nach Filtration durch ein Filter mit Porendurchmesser von 0,2 µm (Millipore) werden die Photoresistlösungen auf käufliche, wie üblich polierte und durch Oxidation mit einer 0,2 µm dicken $SiO_2$-Schicht versehene Siliciumscheiben geschleudert. Durch Variation der Umdrehungszahl werden die Schichtdicken auf ca. 0,9 µm bis 1,2 µm eingestellt.

Die so beschichteten Scheiben werden 30 Minuten bei 90°C getrocknet. Nach dem Abkühlen und Konditionieren auf ein definiertes Raumklima von 23°C und 40 - 50 % relativer Feuchte werden die Wafer in einem Kontaktbelichtungsgerät unter einer handelsüblichen Chrommaske belichtet.

Die Belichtungszeiten betragen für die nach Beschichtungslösung B und C hergestellten Schichten ca. 1 Sekunde, für die nach Beschichtungslösung D und E hergestellten Schichten ca. 3 Sekunden. Nach 10 Minuten Wartezeit für die Beispiele 30, 33, 34 und 36 wird in dem in den Beispielen 1 bis 16 angegebenen Entwickler entwickelt.

In allen Fällen lassen sich Bildelemente im Bereich von 1 µm einwandfrei auflösen.

Tabelle 4

| Beispiel Nr. | Polymeres Nr. | Beschichtungs-lösung | Entwicklungs-zeit (s) |
|---|---|---|---|
| 26 | 1 | E | 70 |
| 27 | 2 | E | 120 |
| 28 | 3 | E | 70 |
| 29 | 12 | E | 40 |
| 30 | 13 | F | 30 |
| 31 | 14 | D | 70 |
| 32 | 18 | E | 60 |
| 33 | 18 | F | 40 |
| 34 | 20 | F | 50 |
| 35 | 21 | E | 70 |
| 36 | 24 | F | 60 |
| 37 | 26 | D | 30 |

**Patentansprüche**

1. In Wasser unlösliches, in wäßrig-alkalischen Lösungen aber lösliches Polymeres, das wiederkehrende Einheiten der allgemeinen Formel I

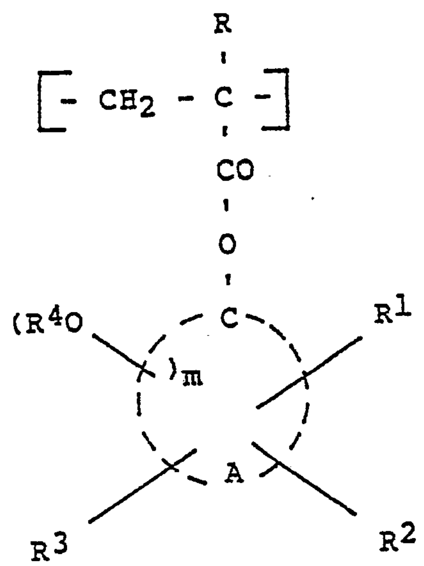

(I)

enthält, worin
R ein Wasserstoff- oder Halogenatom, eine Cyanidgruppe oder eine Alkylgruppe mit 1–4 Kohlenstoffatomen ist,
$R^1$, $R^2$ und $R^3$ gleich oder verschieden sind und Wasserstoff- oder Halogenatome, Alkyl-, Alkoxy- oder Alkoxycarbonylgruppen bedeuten,
$R^4$ ein Wasserstoffatom oder eine zweiwertige organische Gruppe ist, die mit einer weiteren Einheit der

Formel I inter- oder intramolekular verknüpft ist, wobei im Mittel mindestens ein $R^4$ jeder Polymereinheit der Formel I Wasserstoff ist,
A die zur Vervollständigung eines ein- oder zweikernigen carbo- oder heterocyclischen aromatischen Ringsystems erforderlichen Atome bedeuten und
m 2 oder 3 ist.

2. Polymeres nach Anspruch 1, dadurch gekennzeichnet, daß es ferner wiederkehrende Einheiten der allgemeinen Formel II

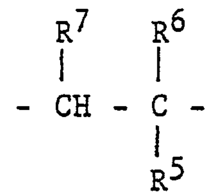

(II)

enthält, worin
$R^5$ ein Wasserstoff- oder Halogenatom oder eine Alkylgruppe,
$R^6$ eine Alkyl-, Alkoxy-, Alkyloxycarbonyl-, Acyl-, Acyloxy-, Aryl-, Formyl-, Cyanid-, Carboxyl-, Hydroxy- oder Aminocarbonylgruppe und
$R^7$ ein Wasserstoffatom oder eine Carbonylgruppe bedeutet, die mit $R^6$, wenn dieses eine Carboxylgruppe ist, zu einem Säureanhydrid verbunden sein kann.

3. Polymeres nach Anspruch 1, dadurch gekennzeichnet, daß A die zur Vervollständigung eines Benzolrings erforderlichen Kohlenstoffatome bedeutet.

4. Polymeres nach Anspruch 1, dadurch gekennzeichnet, daß es ein Molekulargewicht $M_n$ von 1000 bis 200.000 hat.

5. Polymeres nach Anspruch 1, dadurch gekennzeichnet, daß m= 2 ist.

6. Polymeres nach Anspruch 1, dadurch gekennzeichnet, daß es 20 bis 100 mol-% Einheiten der Formel I enthält.

7. Strahlungsempfindliches Gemisch, das als wesentliche Bestandteile
A) ein in Wasser unlösliches, in wäßrig-alkalischen Lösungen lösliches polymeres Bindemittel mit seitenständigen phenolischen Hydroxygruppen und
B)
1) ein 1,2-Chinondiazid oder
2) eine Kombination aus
a) einer unteren Einwirkung von aktinischer Strahlung eine starke Säure bildenden Verbindung und
b) einer Verbindung mit mindestens einer durch Säure spaltbaren C-O-C-Bindung enthält, deren Löslichkeit in einem Entwickler durch Einwirkung von Säure erhöht wird,
dadurch gekennzeichnet, daß das Bindemittel ein Polymeres gemäß den Ansprüchen 1 oder 2 ist.

8. Strahlungsempfindliches Aufzeichnungsmaterial mit einem Schichtträger und einer strahlungsempfindlichen Aufzeichnungsschicht, die als wesentliche Bestandteile
A) ein in Wasser unlösliches, in wäßrig-alkalischen Lösungen lösliches polymeres Bindemittel mit seitenständigen phenolischen Hydroxygruppen und
B)
1) ein 1,2-Chinondiazid oder
2) eine Kombination aus
a) einer unter Einwirkung von aktinischer Strahlung eine starke Säure bildenden Verbindung und
b) einer Verbindung mit mindestens einer durch Säure spaltbaren C-O-C-Bindung enthält, deren Löslichkeit in einem Entwickler durch Einwirkung von Säure erhöht wird,
dadurch gekennzeichnet, daß das Bindemittel ein Polymeres gemäß Anspruch 1 ist.

9. Verfahren zur Herstellung von Reliefbildern, dadurch gekennzeichnet, daß man ein strahlungsempfindliches Aufzeichnungsmaterial gemäß Anspruch 8 bildmäßig mit aktinischer Strahlung in solcher Dosis bestrahlt, daß die Löslichkeit der Aufzeichnungsschicht in einer wäßrig-alkalischen Entwicklerlösung zunimmt, und die bestrahlten Schichtteile mittels einer wäßrig-alkalischen Entwicklerlösung auswäscht.

**Claims**

1. A polymer which is insoluble in water, but soluble in aqueous alkaline solutions and which contains repeating units of the general formula I

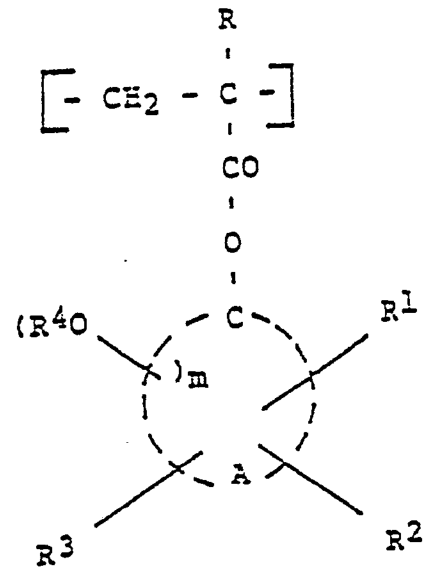

(1)

in which
R is a hydrogen or halogen atom, a cyanide group or an alkyl group of 1–4 carbon atoms,
$R^1$, $R^2$ and $R^3$ are identical or different and denote hydrogen or halogen atoms, alkyl, alkoxy or alkoxycarbonyl groups,
$R^4$ is a hydrogen atom or a divalent organic group which is intermolecularly or intramolecularly linked to a further unit of the formula I, on average at least one $R^4$ of each polymer unit corresponding to formula I being hydrogen,
A denotes the atoms required for completing a mononuclear or dinuclear carbocyclic or heterocyclic aromatic ring system and
m is 2 or 3.

2. The polymer as claimed in claim 1, characterized in that it contains repeating units of the general formula II

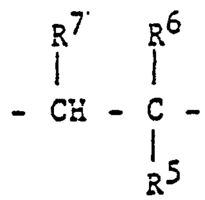

(II)

in which
$R^5$ is a hydrogen or halogen atom or an alkyl group,
$R^6$ is an alkyl, alkoxy, alkyloxycarbonyl, acyl, acyloxy, aryl, formyl, cyanide, carboxyl, hydroxyl or aminocarbonyl group and
$R^7$ denotes a hydrogen atom or a carbonyl group which can be bonded to $R^6$, when the latter is a carboxyl group, to form an acid anhydride.

3. The polymer as claimed in claim 1, characterized in that A denotes the carbon atoms required for completing a benzene ring.

4. The polymer as claimed in claim 1, characterized in that it has a molecular weight $M_n$ of 1,000 to 2,000.

5. The polymer as claimed in claim 1, characterized in that m is 2.

6. The polymer as claimed in claim 1, characterized in that it contains 20 to 100 mol-% of units of formula I.

7. A radiation-sensitive mixture which contains as essential constituents
A) a water-insoluble polymeric binder which is soluble in aqueous alkaline solutions and has phenolic hydroxyl side groups and
B)
1) a 1,2-quinonediazide or
2) a combination of
a) a compound which forms a strong acid under the action of actinic radiation and
b) a compound which has at least one acid-cleavable C-O-C bond and the solubility of which in a developer is increased by the action of acid,

characterized in that the binder is a polymer as claimed in any of claims 1 or 2.

8. A radiation-sensitive recording material comprising a layer support and a radiation-sensitive recording layer which contains as essential constituents

A) a water-insoluble polymeric binder which is soluble in aqueous alkaline solutions and has phenolic hydroxyl side groups and

B)

1) a 1,2-quinonediazide or

2) a combination of

a) a compound which forms a strong acid under the action of actinic radiation and

b) a compound which has at least one acid-cleavable C-O-C bond and the solubility of which in a developer is increased by the action of acid,

characterized in that the binder is a polymer as claimed in claim 1.

9. A process for preparing relief images, characterized in that a radiation-sensitive recording material as claimed in Claim 8 is imagewise irradiated with actinic radiation in such an amount that the solubility of the recording layer in an aqueous-alkaline developer solution increases, and in that the irradiated parts of the layer are washed out by means of an aqueous-alkaline developer solution.

**Revendications**

1. Polymère insoluble dans l'eau mais soluble dans des solutions aqueuses alcalines, qui contient des motifs répétitifs de formule générale I

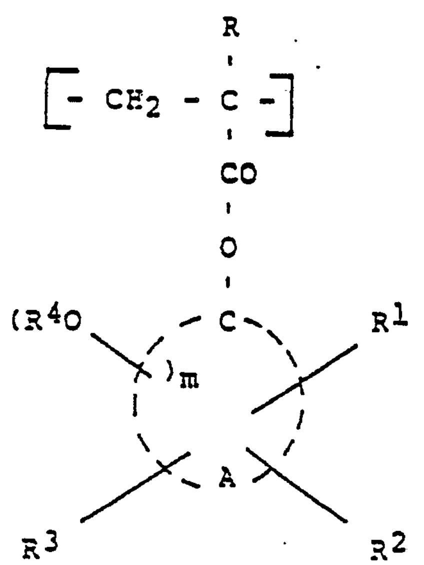

(I)

dans laquelle

R est un atome d'hydrogène ou d'halogène, le groupe cyano ou un groupe alkyle ayant de 1 à 4 atomes de carbone,

$R^1$, $R^2$ et $R^3$ sont identiques ou différents, et représentent des atomes d'hydrogène ou d'halogène, des groupes alkyle, alcoxy ou alcoxycarbonyle,

$R^4$ est un atome d'hydrogène ou un groupe organique bivalent qui est lié par liaison inter- ou intramoléculaire à un autre motif de formule I, en moyenne au moins un $R^4$ de chaque motif de polymère de formule I étant un atome d'hydrogène,

A représente les atomes requis pour le complément d'un système cyclique aromatique carbocyclique ou hétérocyclique mono- ou bicyclique, et

m est 2 ou 3.

2. Polymère selon la revendication 1, caractérisé en ce qu'il contient en outre des motifs répétitifs de formule générale II

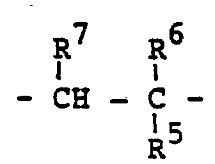

(II)

dans laquelle

$R^5$ est un atome d'hydrogène ou d'halogène ou un groupe alkyle,

$R^6$ est un groupe alkyle, alcoxy, alkyloxycarbonyle, acyle, acyloxy, aryle, formyle, cyano, carboxy, hydroxy ou amino-carbonyle, et

$R^7$ est un atome d'hydrogène ou un groupe carboxy qui peut être lié à $R^6$, lorsque celui-ci est un groupe carboxy, pour donner un anhydride d'acide.

3. Polymère selon la revendication 1, caractérisé en ce que A représente les atomes de carbone requis pour le complément d'un cycle benzénique.

4. Polymère selon la revendication 1, caractérisé en ce qu'il possède une masse moléculaire $M_n$ de 1000 à 200 000.

5. Polymère selon la revendication 1, caractérisé en ce que m = 2.

6. Polymère selon la revendication 1, caractérisé en ce qu'il contient de 20 à 100% en mole de motifs de formule I.

7. Composition sensible aux radiations, qui contient en tant que composants essentiels

A) un liant polymère à groupes hydroxy phénoliques latéraux, insoluble dans l'eau, soluble dans des solutions aqueuses alcalines, et

B)

1) un 1,2-quinonediazide ou

2) une combinaison de

a) un composé formant un acide fort sous l'effet d'un rayonnement actinique et

b) un composé comportant au moins une liaison C-O-C pouvant être rompue par un acide, dont la solubilité dans un révélateur est accrue sous l'effet d'un acide,

caractérisée en ce que le liant est un polymère selon la revendication 1 ou 2.

8. Matériau de reprographie sensible aux radiations, comportant un support de couche et une couche de reproduction sensible aux radiations, qui contient en tant que composants essentiels

A) un liant polymère à groupes hydroxy phénoliques latéraux, insoluble dans l'eau, soluble dans des solutions aqueuses alcalines, et

B)

1) un 1,2-quinonediazide ou

2) une combinaison de

a) un composé formant un acide fort sous l'effet d'un rayonnement actinique et

b) un composé comportant au moins une liaison C-O-C pouvant être rompue par un acide, dont la solubilité dans un révélateur est accrue sous l'effet d'un acide,

caractérisé en ce que le liant est un polymère selon la revendication 1.

9. Procédé pour la production d'images en relief, caractérisé en ce que l'on expose selon une image un matériau de reprographie sensible aux radiations, selon la revendication 8, avec un rayonnement actinique en une dose telle que la solubilité de la couche de reproduction dans une solution aqueuse alcaline de développement augmente, et on élimine les parties irradiées de la couche par lavage à l'aide d'une solution aqueuse alcaline de développement.